**Europäisches Patentamt**

**European Patent Office**

**Office européen des brevets**

(11) Numéro de publication: **0 213 968**
**B1**

# FASCICULE DE BREVET EUROPEEN

(45) Date de publication du fascicule du brevet:
**07.02.90**

(21) Numéro de dépôt: **86400843.8**

(22) Date de dépôt: **18.04.86**

(51) Int. Cl.⁴: **H05K 3/30,** H01R 13/73,
**H05K 3/34**

(54) **Procédé de fixation d'un connecteur sur le substrat d'un circuit imprimé au moyen de pions de fixation.**

(30) Priorité: **23.04.85 FR 8506163**

(43) Date de publication de la demande:
**11.03.87 Bulletin 87/11**

(45) Mention de la délivrance du brevet:
**07.02.90 Bulletin 90/6**

(84) Etats contractants désignés:
**AT BE CH DE GB IT LI LU NL SE**

(56) Documents cités:
**EP-A- 0 124 424**
**DE-A- 1 540 251**
**FR-A- 2 315 781**
**FR-A- 2 353 970**
**FR-A- 2 406 323**

(73) Titulaire: **CGEE ALSTHOM Direction RED Société
Anonyme:, 5, Avenue Newton, F-92140 Clamart(FR)**

(72) Inventeur: **Le Diraison, Pierre, 4, rue H. Rabourdin,
F-78140 Velizy-Villacoublay(FR)**
Inventeur: **Pichon, Bernard, 35 Le Verseau 58, rue de
l'Egalité, F-92130 Issy Les Moulineaux(FR)**
Inventeur: **Trequilly, Yves, 18 Bis, rue de la Belgique,
F-92190 Meudon(FR)**

(74) Mandataire: **Mongrédien, André et al, c/o
BREVATOME 25, rue de Ponthieu, F-75008 Paris(FR)**

ACTORUM AG

## Description

La présente invention a pour objet un procédé de fixation d'un connecteur sur le substrat d'un circuit imprimé par pion de fixation dudit connecteur sur ce substrat.

Dans le cadre d'une fabrication en série et lors de la mise en oeuvre de circuits imprimés, la mise en place et le branchement des connecteurs sur ces circuits s'effectuent habituellement de la manière suivante.

Le connecteur est tout d'abord positionné aux emplacements prévus sur le circuit imprimé, les queues de connexion à souder de ce connecteur traversant des trous prévus dans le substrat du circuit. Le connecteur est alors fixé au substrat à l'aide de rivets ou de boulons, voir par ex. FR-A 2 353 970. Puis le connecteur et les autres composants sont soudés sur le circuit par exemple "à la vague", c'est-à-dire que le circuit imprimé et les parties des composants qui en font saillie sont "trempés" pendant un court instant dans un bain de soudure. Les queues sont alors soudées sur le circuit, un dépôt de soudure étant inutilement déposé sur les rivets et boulons de fixation.

Ces moyens de fixation ne servent qu'à maintenir le connecteur en place lors des manipulations précédant le soudage. Or, la pose de rivets et de boulons est une opération longue, onéreuse et peu pratique ; donc, se servir de tels moyens pour maintenir temporairement le connecteur sur le circuit est inutile.

L'invention a justement pour objet un procédé de fixation d'un connecteur sur le substrat d'un circuit imprimé et un pion de fixation dudit connecteur sur ce substrat permettant de pallier les inconvénients susmentionnés.

De façon plus précise, le procédé de fixation d'un connecteur sur le substrat d'un circuit imprimé comporte les étapes suivantes :
- le positionnement d'une première face du connecteur, munie de queues de connexion à souder, contre une face du substrat, lesdites queues traversant des trous ménagés dans le substrat, au moins un trou de fixation du connecteur étant en regard d'un trou de fixation du substrat ;
- la mise en place d'un pion de fixation dans chacun des trous de fixation en regard du connecteur et du substrat, de telle sorte que le pion vient prendre appui sur une deuxième face du connecteur opposée à ladite première face, et se coince dans le substrat, réalisant ainsi une liaison temporaire entre le connecteur et le substrat ;
- le dépôt de soudure sur une extrémité du pion de fixation en saillie par rapport au substrat, réalisant ainsi la fixation du connecteur sur le substrat.

Avantageusement, le dépôt de soudure est réalisé en même temps que le soudage desdites queues à souder sur le circuit imprimé par trempage dans un bain de soudure.

Commodément, le pion de fixation d'un connecteur sur le substrat d'un circuit imprimé selon le procédé décrit auparavant comporte une première partie cylindrique apte à pénétrer dans le trou de fixation du connecteur, une seconde partie cylindrique apte à pénétrer dans le trou de fixation du substrat, des stries formées en saillie sur cette seconde partie cylindrique, aptes à coincer le pion dans ledit trou de fixation du substrat, un épaulement formé à l'extrémité libre de la première partie cylindrique apte à prendre appui sur ladite seconde face du connecteur, la seconde partie cylindrique faisant saillie du substrat lorsque l'épaulement prend appui sur ladite seconde face de façon à pouvoir recevoir un dépôt de soudure.

La figure 1 représente à titre d'exemple, en coupe longitudinale, le connecteur branché et fixé sur le substrat du circuit imprimé.

La figure 2 représente une vue en plan du pion de fixation selon l'invention.

La figure 3 représente une coupe selon le plan A-A de la figure 2 du pion de fixation.

La figure 4 représente schématiquement, en perspective, et en vue de dessous, le substrat du circuit imprimé, le connecteur et le bain de soudure.

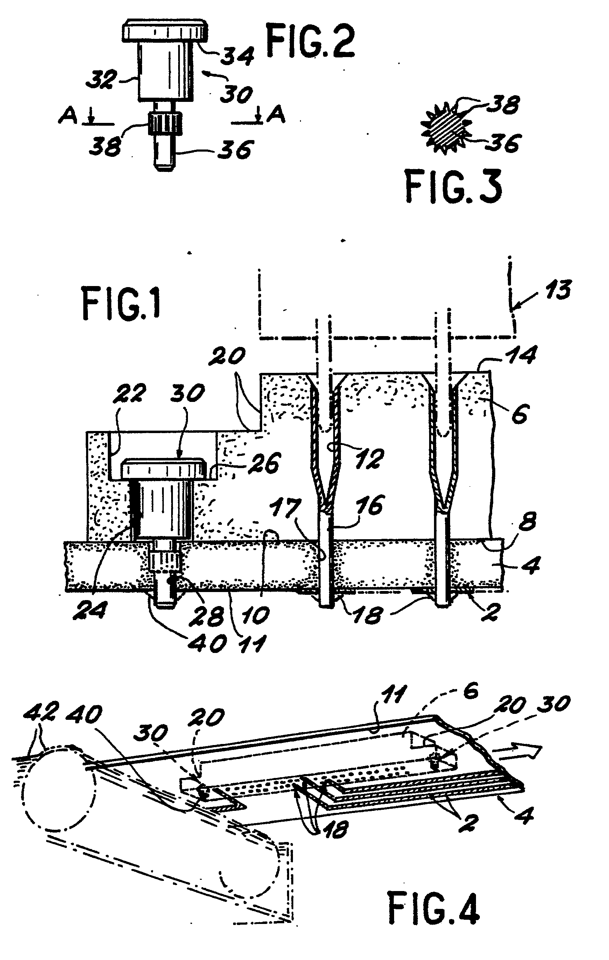

Un circuit imprimé 2, son substrat 4 et un connecteur 6 branché et fixé sur ce circuit 2 sont représentés sur la figure 1.

Le connecteur 6 se présente habituellement sous la forme d'un parallélépipède rectangle allongé. Lorsqu'il est monté sur le circuit imprimé 2, il est appliqué par une première face 8 contre une face 10 du substrat 4 opposée à une face 11 du même substrat 4 sur laquelle le circuit 2 servant à la connexion est imprimé.

Des queues de connexion mâles ou femelles 12 sont noyées dans le connecteur, leur axe étant normal à la première face 8. Leurs entrées, situées sur une face 14 du connecteur opposée à la face 8, sont aptes à recevoir une prise de connexion 13 (en traits mixtes sur la figure 1). Chacune des queues 12 se prolonge suivant son axe par une queue deconnexion à souder 16. Celles-ci font saillie de la première face 8 de telle sorte que ces queues 16 traversent des trous 17 formés dans le substrat 4 et font également saillie du circuit imprimé 2. Chacune de ces queues de connexion à souder 16 est soudée sur ce circuit 2 par un cordon de soudure référencé 18.

A chaque extrémité longitudinale du connecteur 6, une encoche 20 est formée, constituant une "marche d'escalier" avec ladite face 14. Un lamage 22 et un trou de fixation 24 sont formés à partir de cette encoche 20 suivant un axe normal à la première face 8. Le fond du lamage 22 forme une deuxième face 26 du connecteur parallèle à la face 8.

Un trou de fixation 28 est formé dans le substrat 4, coaxialement au trou de fixation 24 du connecteur mais d'un diamètre plus petit.

Les trous de fixation 24, 28 sont aptes à recevoir un pion de fixation 30. Ce pion est représenté de façon détaillée sur les figures 2 et 3.

Le pion de fixation 30 comporte une première partie cylindrique 32 apte à pénétrer librement dans le trou 24 du connecteur 6. Cette partie 32 est limitée à une extrémité par un épaulement 34 et se prolonge à l'autre extrémité par une seconde partie cylindrique 36 apte à pénétrer dans le trou 28 du substrat 4. Des stries 38 d'un diamètre extérieur supérieur au diamètre du trou 28 du substrat 4 font saillie longitudinalement sur la seconde partie cylindrique 36 suivant toute sa circonférence (figure 3).

Lorsque le pion 30 prend appui par son épaulement 34 sur la seconde face 26 du connecteur 6, la première partie cylindrique 32 est d'une longueur sensiblement inférieure à la distance entre ladite face 26 et les faces 8 et 10 en contact pour ne pas prendre appui sur la face 10. Les stries 38, situées alors sensiblement au milieu du substrat 4 entre les faces 10 et 11, se coincent dans ledit substrat 4, la seconde partie cylindrique 36 faisant saillie de la face 11 du substrat 4.

Le pion de fixation 30 permet donc le maintien temporaire du connecteur 6 sur le substrat 4 par blocage de ces éléments 6, 4 entre l'épaulement 34 et les stries 38.

La fixation définitive du pion se fait par un dépôt de soudure 40 (figure 1) sur l'extrémité en saillie de la seconde partie cylindrique 36 par rapport à la face 11 du substrat 4, le connecteur 6 et le substrat 4 étant alors bloqués entre l'épaulement 34 et le dépôt 40.

Le procédé de fixation du connecteur 6 sur le substrat 4 du circuit imprimé 2 va maintenant être explicité à l'aide de la figure 4.

La première face 8 du connecteur 6 est tout d'abord positionnée contre la face 10 du substrat, de telle sorte que les queues de connexion à souder 16 traversent les trous 17 du substrat prévus cet effet. Chaque trou de fixation 24 du connecteur est alors en regard du trou 28 correspondant du substrat.

Chaque pion de fixation 30 est alors mis en place et enfoncé dans chacun desdits trous 24, 28 jusqu'à ce que l'épaulement 34 du pion 30 prenne appui contre la face 26 du connecteur, les stries 28 allant se coincer dans le substrat 4. On réalise ainsi de façon simple et rapide un maintien temporaire entre le connecteur et le substrat. On peut ainsi manipuler le substrat sans risquer le déboîtement du connecteur.

On effectue ensuite l'opération de soudage des queues à souder 16 sur le circuit imprimé 2 et le dépôt de soudure 40 sur l'extrémité en saillie des pions de fixation 30 par rapport la face 11 du substrat 4. Ces opérations peuvent s'effectuer avanta geusement par soudage "à la vague", comme représenté sur la figure 4.

La face 11 du substrat est translatée audessus de la surface d'un bain de soudure 42 sur lequel on crée artificiellement une vague. Cette vague affleure ladite face 11, réalisant en continu toutes les soudures du circuit imprimé dont, entre autres, celles des queues à souder, et dans le même temps, le dépôt de soudure 40 sur chaque pion de fixation 30.

On réalise ainsi la fixation définitive du connecteur 6 sur le substrat 4.

Bien entendu, la description ci-dessus n'a été donnée qu'à titre d'exemple, toutes modifications dans les formes de réalisation pouvant être envisagées sans modifier le principe fondamental de l'invention.

On peut ainsi envisager un pion de fixation dont les première et seconde parties cylindriques 32, 36 sont de même diamètre, le diamètre du trou 28 restant inférieur celui du trou 24. Les stries 38 peuvent être de forme quelconque et être formées par exemple par moletage.

## Revendications

1. Procédé de fixation d'un connecteur (6) sur le substrat (4) d'un circuit imprimé (2), caractérisé en ce qu'il comporte les étapes suivantes :
- le positionnement d'une première face (8) du connecteur (6), munie de queues de connexion à souder (16) contre une face (10) du substrat (4), lesdites queues (16) traversant des trous (17) ménagés dans le substrat (4), au moins un trou de fixation (24) du connecteur (6) étant en regard avec un trou de fixation (28) du substrat (4) ;
- la mise en place d'un pion de fixation (30) dans chacun des trous de fixation (24, 28) en regard du connecteur (6) et du substrat (4), de telle sorte que le pion (30) vient prendre appui sur une deuxième face (26) du connecteur opposée à ladite première face (8) et se coincer dans le substrat (4), réalisant ainsi une liaison temporaire entre le connecteur (6) et le substrat (4) ;
- le dépôt de soudure (40) sur une extrémité du pion de fixation (30) en saillie par rapport au substrat (4), réalisant ainsi la fixation du connecteur (6) sur le substrat (4).

2. Procédé selon la revendication 1, caractérisé en ce que le dépôt de soudure (40) est réalisé en même temps que le soudage desdites queues à souder (16) sur le circuit imprimé (2) par trempage dans un bain de soudure.

3. Pion de fixation (30) d'un connecteur (6) sur le substrat (4) d'un circuit imprimé (2) selon le procédé de la revendication 1, caractérisé en ce qu'il comporte une première partie cylindrique (32) apte à pénétrer dans le trou de fixation (24) du connecteur (6), une seconde partie cylindrique (36) apte à pénétrer dans le trou de fixation (28) du substrat (4), des stries (38) formées en saillie sur cette seconde partie cylindrique (36) aptes à coincer le pion (30) dans ledit trou de fixation (28) du substrat (4), un épaulement (34) formé à l'extrémité libre de la première partie cylindrique (32) apte à prendre appui sur ladite seconde face (26) du connecteur (6), la seconde partie cylindrique (36) faisant saillie du substrat (4) lorsque l'épaulement (34) prend appui sur ladite seconde face (26) de façon à pouvoir recevoir un dépôt de soudure (40).

## Claims

1. Method for fixing a connecting piece (6) to the substrate (4) of a printed circuit (2), characterised in that it comprises the following stages:
- positioning a first surface (8) of the connecting piece (6), equipped with solder connecting pins (16), against a surface (10) of the substrate (4), the said pins (16) passing through holes (17) provided in the substrate (4), at least one fixing hole (24) of the connecting piece (6) being opposite a fixing hole (28) of the substrate (4);
- inserting a fixing stud (30) into each of the fixing holes (24, 28) opposite the connecting piece (6) and the substrate (4) so that the stud (30) comes to bear against a second surface (26) of the connecting piece, which is opposite the said first surface (8), and becomes wedged into the substrate (4), thus forming a temporary bond between the connecting piece (6) and the substrate (4);
– depositing solder (40) at one end of the fixing stud (30) which projects relative to the substrate (4), thus effecting the fixing of the connecting piece (6) to the substrate (4).

2. Method according to Claim 1, characterised in that the solder (40) is deposited at the same time as the soldering of the said solder pins (16) to the printed circuit (2) by immersing in a soldering bath.

3. Stud (30) for fixing a connecting piece (6) to the substrate (4) of a printed circuit (2) according to the method of Claim 1, characterised in that it comprises a first cylindrical part (32) which can penetrate the fixing hole (24) of the connecting piece (6), a second cylindrical part (36) which can penetrate the fixing hole (28) of the substrate (4), serrations (38) which are formed so as to project from this second cylindrical part (36) and can wedge the stud (30) into the said fixing hole (28) of the substrate (4), and a shoulder (34) which is formed at the free end of the first cylindrical part (32) and can bear against the said second surface (26) of the connecting piece (6), the second cylindrical part (36) projecting from the substrate (4) when the shoulder (34) bears against the said second surface (26) so as to be able to receive a solder deposit (40).

**Patentansprüche**

1. Verfahren zur Befestigung eines Verbinders (6) an einem Substrat (4) einer gedruckten Schaltung (2), dadurch gekennzeichnet, daß es die folgenden Schritte umfaßt:
– das Aufsetzen einer ersten Fläche (8) des Verbinders (6), die mit Lötverbindungsfahnen (16) versehen ist, auf eine Fläche (10) des Substrats (4), wobei die genannten Fahnen (16) Löcher (17) durchqueren, die in dem Substrat (4) ausgebildet sind, wobei wenigstens ein Befestigungsloch (24) des Verbinders (6) einem Befestigungsloch (26) des Substrats (4) gegenübersteht;
– das Anbringen eines Befestigungsstiftes (30) in jedem der sich gegenüberstehenden Befestigungslöcher (24, 28) des Verbinders (6) und des Substrats (4) derart, daß der Stift (30) sich auf eine zweite Fläche (26) des Verbinders, die der erstgenannten Fläche (8) abgewandt ist, angelegt und sich in dem Substrat (4) verkeilt, so daß so eine vorübergehende Verbindung zwischen dem Verbinder (6) und dem Substrat (4) hergestellt wird;
– Aufbringen von Lötmittel (40) auf ein Ende des Befestigungsstiftes (30), das gegenüber dem Substrat (4) vorsteht, um auf diese Weise die Befestigung des Verbinders (6) an dem Substrat (4) auszuführen.

2. Verfahren nach Anspruch 1, dadurch gekennzeichnet, daß das Aufbringen des Lötmittels (40) gleichzeitig wie das Auflöten der Lötfahnen (16) auf die gedruckte Schaltung (2) durch Eintauchen in ein Lötbad ausgeführt wird.

3. Stift (30) zur Befestigung eines Verbinders (6) auf dem Substrat (4) einer gedruckten Schaltung (2) nach dem Verfahren nach Anspruch 1, dadurch gekennzeichnet, daß er einen ersten zylindrischen Abschnitt (32), der zum Eindringen in das Befestigungsloch (24) des Verbinders (6) bestimmt ist, einen zweiten zylindrischen Abschnitt (36), der zum Eindringen in das Befestigungsloch (28) des Substrats bestimmt ist, von dem genannten zweiten zylindrischen Abschnitt (36) vorstehende Rippen (38), die zum Festklemmen des Stiftes (30) in dem Befestigungsloch (28) des Substrats (49) bestimmt sind, und eine Schulter (34), die am freien Ende des ersten zylindrischen Abschnittes (32) ausgebildet und dazu bestimmt ist, sich auf die genannte zweite Fläche (26) des Verbinders (6) aufzulegen, aufweist, wobei der zweite zylindrische Abschnitt (36) von dem Substrat (4) vorsteht, wenn die Schulter (34) auf der genannten zweiten Fläche (26) aufliegt, um ein Lötmitteldepot (40) aufnehmen zu können.

FIG.2

34

32

30

A     A

38     36

38

36

FIG.3

FIG.1

13

20

14

22     30

6

26

12

17     16

8

4

24     28   10     18     2

40   11

42 40     30     20

11     6     20 30

30     20

2     4

18

FIG.4